# EUROPEAN PATENT SPECIFICATION

(11) **EP 0 481 734 B1**
(45) Date of publication and mention of the grant of the patent: **29.12.1999**
(21) Application number: 91309495.9
(22) Date of filing: 15.10.1991
(51) Int. Cl.: H01L 27/12, H01L 29/78, G02F 1/136

(54) **Light valve device**
Lichtventil Vorrichtung
Dispositif obturateur de lumière

(30) Priority: 16.10.1990 JP 27743690
(43) Date of publication of application: 22.04.1992
(73) Proprietor: AGENCY OF INDUSTRIAL SCIENCE AND TECHNOLOGY, Chiyoda-ku Tokyo (JP); SEIKO INSTRUMENTS INC., Tokyo 136 (JP)
(72) Inventor: Hayashi, Yutaka, c/o Agency of Industrial Science, Tsukaba-shi Ibaragi (JP); Kamiya, Masaaki, c/o Seiko Instruments Inc., Koto-ku, Tokyo (JP); Kojima, Yoshikazu, c/o Seiko Instruments Inc., Koto-ku, Tokyo (JP); Takasu, Hiroaki, c/o Seiko Instruments Inc., Koto-ku, Tokyo (JP)
(74) Representative: Sturt, Clifford Mark

(56) References cited:
- EP-A- 0 136 509
- US-A- 4 609 930
- US-A- 4 748 485
- US-A- 4 751 196
- US-A- 4 875 086
- ELECTRONICS LETTERS vol. 25, no. 15, 20 July 1989, ENAGE GB pages 1009 - 1011 R. P. ZINGG ET AL 'HIGH-QUALITY DUAL-GATE PMOS DEVICES IN LOCAL OVERGROWTH (LOG)'
- PATENT ABSTRACTS OF JAPAN vol. 8, no. 70 (E-235)(1507) 3 April 1984

## Description

The present invention relates to light valve devices of a flat plate type, such as active matrix liquid crystal panels for displays of a direct viewing type or of a projection type. More specifically, the invention relates to a semiconductor device for providing a substrate of such a liquid crystal panel.

An active matrix device is based on a simple principle, in which each pixel is equipped with a switching element and, when a particular pixel is selected, the corresponding switching element is made to be conductive and, when it is not selected, the switching element is made to be non-conductive. The switching elements are formed on a glass substrate which forms part of the device. Therefore, the technology for miniaturising the switching elements and making them thin is very important. Thin film transistors are ordinarily used as such switching elements.

In a conventional active matrix device, a thin film transistor has so far been formed on a thin silicon film that is deposited on the glass substrate. Such transistors are generally of an insulated gate field effect type. A transistor of this type has a channel region formed in the thin silicon film and a gate electrode formed so as to cover the channel region. A predetermined voltage is applied to the gate electrode to control the conductance of the channel region and to carry out the switching operation.

The conventional insulated gate-type thin film transistors have a problem in that a leakage current may flow into the channel region through the back side of the thin film even when the channel region is made non-conductive by controlling the gate voltage. That is, so-called "back channel" or "backgating" takes place impairing the proper operation of the active matrix device. In order to operate the pixels at high speeds by a line sequence system, the conductance ratio of the switching elements, between the conductive state and the non-conductive state, must be greater than 10 . In fact, however, the back-gating makes it difficult to obtain the required switching performance.

Even if the back-gating were eliminated, the channel region of the thin-film transistor tends to exhibit an increased conductance if light from an external source falls thereon, the semiconductor device being used under an illuminated condition, and this causes leakage current in the drain and source in the non-conductive state. Further, the ratio of this leakage current to the leakage current when no light enters increases with an increase in the quality of the semiconductor thin film, such as a single crystal film, that forms the channel regions, causing another problem.

Attempts have been made to address these problems and discussions of which can be found in EP-A-136 509 and US -A-4875086. In particular a device according to the preamble of claim 1 is known from EP-A-0 136 509.

In view of the above-mentioned problems, it is an object of the present invention at least in its preferred form to provide a semiconductor device for driving light valves of a flat plate type, which has thin film transistors with a structure capable of effectively preventing back-gating and of blocking incident light.

The object is met by the device as claimed in claim 1 of the claims attached hereto and a method of producing a device as claimed in claim 6.

A semiconductor according to the present invention comprises a substrate having a stacked structure, which includes an insulating support substrate made of a light transmitting material, a light shielding thin film provided on the support substrate, and a semiconductor thin film provided on the light-shielding thin film via an insulating film. Transparent electrodes for driving light valves, i.e. pixel electrodes, are arranged on the support substrate. Furthermore, switching elements are provided for selectively exciting the pixel electrodes. Each of theswitching elements comprises an insulated gate field effect transistor having a channel region and main gate electrode for controlling the channel region. A channel region is formed in the semiconductor thin film, and the main gate electrode is formed so as to cover the channel region. The light shielding thin film is provided on the side of the channel region opposite the main gate electrode so that the channel region is sandwiched between the main gate electrode and the light shielding thin film in the vertical direction.

Preferably, the main gate electrode is also made of a light shielding material and together with the light shielding thin film substantially entirely blocks light from reaching the channel region from the outside.

The light shielding thin film is made of an electrically conductive material to eliminate back-gating. The light shielding thin film serves as a sub-gate electrode, and is arranged to receive an electric current in order to control back-gating.

Since the semi-conductor thin film is a single crystal silicon thin film, the channel region can be precisely fabricated to within the order of sub-microns using ordinary LSI technology.

In the preferred embodiment described below, the conductance of the channel region of each of a plurality of transistors is controlled by main gate and sub-gate electrodes provided on both sides of the semi-conductor thin film via insulating films. Therefore, no back-gating develops, by contrast with the conventional construction, in which a single gate electrode is provided on only one surface of the channel region of a thin film transistor. In other words, the sub-gate electrodes serve to suppress the back-gating.

In addition, since in the preferred embodiment the channel region of each transistor is covered by a couple of light shielding gate electrodes from both the upper and the lower sides, light incident on the device passes through the electrode but is nearly completely blocked from the channel region, rendering it possible effectively to prevent the generation of photoelectric current.

The invention is described further, by way of example, with reference to the accompanying drawings, in which:-
Figure 1 is partial sectional view through a flat-type semiconductor device according to the invention for driving a light valve device;
Figure 2 is a partial sectional view through a composite substrate employed for fabricating the semiconductor device of Figure 1;
Figures 3(A) to 3(H) are schematic diagrams illustrating different steps in the fabrication of the semiconductor device of Figure 1;
Figures 4(A) to 4(J) are schematic diagrams illustrating different steps in the fabrication of a further semiconductor device according to the invention; and
Figure 5 is a perspective exploded view, which schematically illustrates the structure of a light valve device of a flat plate type incorporating the semiconductor device according to the invention.

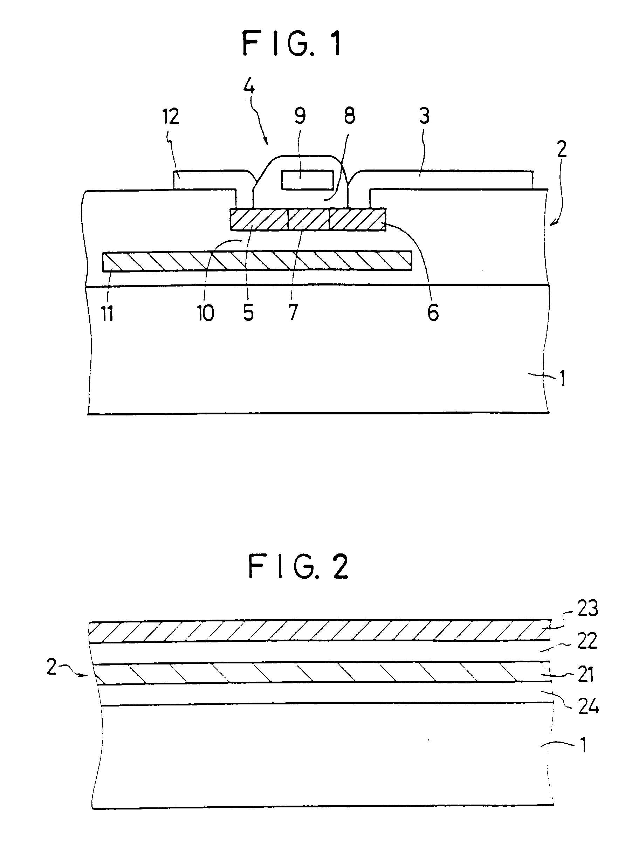

Figure 1 is a schematic partial sectional view of a semiconductor device for driving a light valve device of a flat plate type. The semiconductor device comprises a laminated layer structure 2 formed on a support substrate 1. The laminated layer structure 2 includes a light shielding thin film and a semiconductor thin film formed on the light shielding thin film via an insulating film as described below. A transparent electrode for driving a respective light valve, i.e. a pixel electrode 3, is formed on the surface of the composite substrate including the stacked-layer structure 2. Further, a corresponding switching element 4 is formed in the stacked-layer structure 2 for selectively exciting the pixel electrode 3.

The switching element 4 has a drain region 5 and a source region 6, both formed in the semiconductor thin film and spaced apart from each other. The drain region 5 is connected to a signal line 12 and the source region 6 is connected to the corresponding pixel electrode 3. Moreover, a channel region 7 is provided between the drain region 5 and the source region 6. A main gate electrode 9 is formed on the front surface of the channel region 7 via the gate insulating film 8. The main gate electrode 9 is connected to a scanning line (not shown) and controls the conductance of the channel region 7 in order to turn the switching element 4 on or off.

The light-shielding thin film forms a light-shielding layer 11 arranged on the back surface side of the channel region 7 via an insulating layer 10 provided by the insulating film. That is, the light-shielding layer 11 is arranged on the side of the channel region 7 opposite to the main gate electrode 9. The light-shielding layer 11 is provided by the aforementioned light-shielding thin film as mentioned above and, in this instance, is electrically conductive so that it also serves as a sub-gate electrode to control back-gating.

The pair of main and sub-gate electrodes 9 and 11 arranged on both sides of the channel region 7 are made of light-shielding material and, hence, completely prevent light from falling on the channel region 7.

In this embodiment, furthermore the channel region 7 is formed of a single silicon crystal semiconductor thin film, to which ordinary LSI processing technogoloy can be directly adapted. Therefore, the channel length can be shortened to the order of submicrons.

Figure 2 is a schematic partial sectional view of the composite substrate employed for fabricating the semiconductor device of Figure 1. The composite substrate consists of the support substrate 1 and the stacked-layer structure 2 formed thereon as shown.

First, the support substrate 1 is composed of a light-transmitting insulating material, such as a heat-resistant quartz consisting chiefly of silicon oxide or aluminium oxide. Aluminium oxide exhibits a coefficient of thermal expansion which is close to that of silicon and gives advantages in terms of stress suppresion. Furthermore, since single crystals of aluminium oxide can be formed, it is possible to grow a single crystal semiconductor film hetero-epitaxially thereon.

Next, the laminated structure 2 adhered to the support substrate 1 has a light-shielding thin film 21 arranged on the support substrate 1, an insulating film 22 arranged on the above light-shielding thin film 21, and a semi-conductor thin film 23, arranged on the insulating film 22 and composed of a single crystal material. The light-shielding thin film 21 is composed of an electrically conductive material such as polysilicon. Alternatively, it is possible to use a single layer film of germanium, silicon-germanium or silicon, or a multi-layer film of silicon including at least one layer of germanium or silicon-germanium, instead of the single layer film of polysilicon. It is further possible to use a metal film such as a silicide or aluminium instead of the above semiconductor materials. When aluminium oxide, i.e. sapphire, is used as the support substrate, furthermore a single crystal silicon can be hetero-epitaxially grown thereon to form the light-shielding thin film.

The stacked-layer structure 2 may include a ground film 24 interposed between the support substrate 1 and the light shielding thin film 21. The ground film 24 is provided to improve the adhesion between the support substrate 1 and the stacked-layer structure 2. For instance, when the support substrate 1 is quartz that consists mainly of silicon oxide, silicon oxide can be used as the ground film 24. When it is desirable for the ground film 24 to block the infiltration of impurities from the support substrate 1, furthermore, the ground film should be composed of a layer of silicon nitride or oxynitride, or a multilayer film of at least one of these and silicon oxide. In particular, oxynitride is advantageous, since it is capable of accommodating stress.

The insulating film 22 is used as a gate insulating film for the sub-gate electrode, provided by the light-shielding thin film 21, and is composed of, for instance, silicon oxide or silicon nitride. Alternatively, the insulating film 22 may be a multi-layer film of silicon nitride and silicon oxide.

The semiconductor thin film 23 positioned on the top of the stacked-layer structure 2 is made of a single crystalline form. An amorphous silicon thin film or a polycrystalline silicon thin film can easily be deposited on a glass substrate by chemical vapour deposition, and is adaptable to manufacture of an active matrix device having a relatively large screen. When such an amorphous silicon thin film is used, the active matrix liquid crystal device can have a screen size of about three inches (7.62 cm) to ten inches (25.4 cm). In particular, the amorphous silicon film can be formed at a temperature as low as 350° or less, and is suitable for liquid crystal panels of large area. When a polycrystal silicon thin film is used, it is possible to make a small liquid crystal panel of about 2" (5.08 cm).

In the case of a polycrystal silicon thin film, however, the reproducibility of constant elements is poor and variations increase when a transistor having a channel length of the order of submicrons is formed by fine semiconductor processing technology. When amorphous silicon is used, further, high-speed switching cannot be realized even though the submicron processing technology is employed. When a semiconductor thin film of single crystal silicon is used, on the other hand, it is possible to employ fine semiconductor processing technology greatly to increase the density of switching elements and to obtain an ultra-fine light valve device.

Even though the switching element has a channel length of the order of microns, a high channel mobility makes it possible to realize a high-speed operation. It is further possible to integrate peripheral circuits for controlling the switching elements on the same support substrate in a large scale and to control the array of switching elements at high speeds, so that the light valve device manufactured using the semiconductor thin film of single crystal silicon is indispensable for displaying very fine moving pictures.

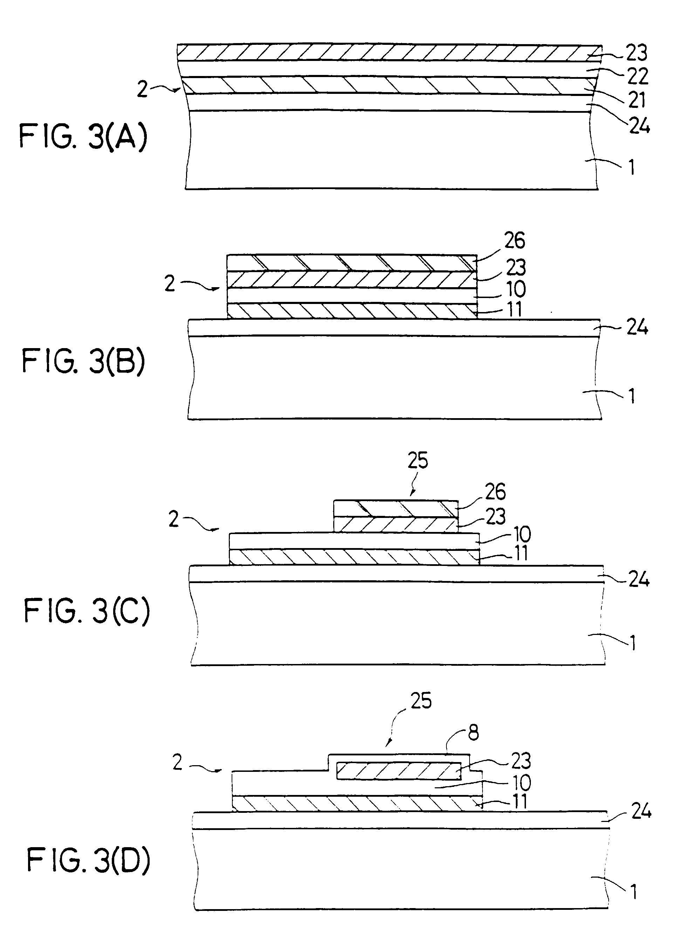

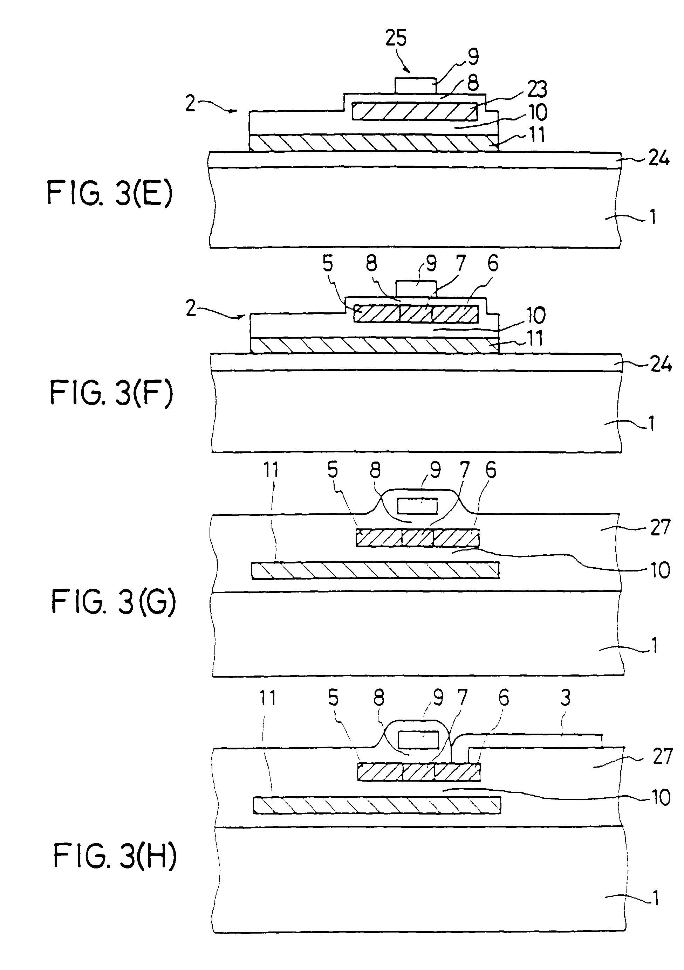

A method of fabricating the semiconductor device according to the present invention is described below in detail with reference to Figure 3. First, a composite substrate is prepared as shown in Figure 3(A). That is, the ground film 24 of silicon oxide is formed on the support substrate 1 of polished quartz plate by a chemical vapour deposition method or by sputtering. The light-shielding thin film 21 made of polysilicon is deposited on the ground film 24 by a chemical vapour deposition method. Then, the insulating film 22 made of silicon oxide is formed on the light-shielding thin film 21 by a thermal oxidation method or by a chemical deposition method. Lastly, the semiconductor thin film 23 of single crystal silicon is formed on the insulating film 22.

The semiconductor thin film 23 is obtained by adhering a semiconductor substrate of single crystal silicon to the insulating film 22 and then polishing it until its thickness becomes several µm. The single crystal silicon semiconductor substrate to be used is preferably a silicon wafer of high quality that is used for manufacturing LSIs having uniform crystal orientation within a range of [100] 0.0 ± 1.0 and a single crystal lattice defect density of smaller than 500 defects/cm². The surface of the silicon wafer having such physical properties is, first, finished precisely and smoothly.

Then, the smoothly finished surface is superposed on the insulating film 22 followed by heating to adhere the silicon wafer to the support substrate 1 by thermo-compression bonding. By means of the thermo-compression bonding, the silicon wafer and the support substrate 1 are firmly adhered to each other. In this state, the silicon wafer is polished until a desired thickness is obtained. It is also possible to carry out an etching process instead of the polishing. The thus obtained single crystal silicon semiconductor thin film 23 substantially retains the quality of the silicon wafer, and therefore a semiconductor substrate material is obtained having excellent uniformity in crystal orientation and a low lattice defect density.

With current technologies, the surface of the silicon wafer that is adhered by thermo-compression bonding has electrical defects to some extent, and the following process is preferred: SiO₂ is formed in the single crystal wafer by thermal oxidation or chemical vapour deposition. Then, polysilicon is formed by chemical vapour deposition and the surface is polished as required. Thereafter, SiO₂ is formed by thermal oxidation or chemical vapour deposition, a silicon nitride film is formed by chemical vapour deposition, and SiO₂ is formed by thermal oxidation or chemical vapour deposition in the order mentioned. The silicon wafer is adhered by thermo-compression bonding onto a quartz support substrate or a quartz support substrate coated with SiO₂ by chemical vapour deposition and is, then, polished.

Next, in a step shown in Figure 3(B), the stacked-layer structure 2, except for the ground film 24, is etched in order to form the light-shielding layer 11 from the light-shielding thin film 21 on the undermost layer, namely, the ground film 24. At the same time, the gate oxide film 10 from the insulating film 22 is formed on the light-shielding layer 11. The light-shielding layer 11 is formed by applying a photosensitive film 26 onto the whole surface of the composite substrate followed by patterning it into a desired shape and, then, effecting etching selectively using the patterned photosensitive film 26 as a mask.

Then, in a step shown in Figure 3(C), an element region 25 is formed on the two-layer structure consisting of the patterned light-shielding layer 11 and the gate oxide film 10. The element region 25 is obtained by selectively etching only the semiconductor thin film 23 into a desired shape. The semiconductor thin film 23 is selectively etched by using, as a mask, the photosensitive film 26 that is further patterned to the shape of the element region 25.

In a step shown in Figure 3(D), furthermore, the photosensitive film 26 is removed and, then, a thermally oxidized film is formed on the whole surface inclusive of the surface of the semiconductor thin film 23 that is exposed. As a result, a gate oxide film 8 is formed on the surface of the semiconductor thin film 23.

Then, in a step shown in Figure 3(E), a polycrystal silicon film is so deposited by a chemical vapour deposition method as to cover the element region 25. The polycrystalline silicon film is selectively etched using a photosensitive film (not shown) that is patterned into a desired shape in order to form the main gate electrode 9. The main gate electrode 9 is positioned above the semiconductor thin film 23 via the gate oxide film 8.

In a step shown in Figure 3(F), impurity ions are injected through the gate oxide film 8 using the main gate electrode 9 as a mask, in order to form the drain region 5 and the source region 6 in the semiconductor thin film 23. As a result, there is formed a transistor channel region 7 that contains no impurity under the main gate electrode 9 between the drain region 5 and the source region 6.

Next, in a step shown in Figure 3(G), a protective film 27 is formed so as to cover the element region 25. As a result, the switching element that includes the light-shielding layer 11 and the main gate electrode 9 is buried under the protective film 27.

Lastly, in a step shown in Figure 3(H), the gate oxide film 8 on the source region 6 is partly removed to form a contact hole, and a transparent pixel electrode 3 is formed so as to cover this portion. The pixel electrode 3 is made of a transparent material such as ITO. In addition, the protective film 27 provided on the lower side of the pixel electrode 3 is made, for example, of silicon oxide and is transparent. Moreover,the support substrate 1 of quartz glass on the lower side thereof is transparent too. Therefore, the three-layer structure consisting of the pixel electorde 3, protective film 27 and quartz glass support substrate 1, is optically transparent and can be utilized for a light valve device of a transmission type.

The pair of main gate and sub-gate electrodes 9 and 11 that sandwich the channel region 7 vertically are made of polysilicon, which is optically opaque in contrast to the above three-layer structure, and hence they block the entering light and prevent leakage current from flowing into the channel region. The incident light can be perfectly blocked by using a material having a low band gap such as silicon, germanium or the like.

In the manufacturing method shown in Figure 3 as described above, the semiconductor thin film 23 of high-quality single crystal silicon is processed at a temperature higher than 600°C, followed by a photolithoetching technique with high resolution and by ion implantation, making it possible to form an insulated gate field-effect transistor having a size of the order of microns or submicrons. A single crystal silicon film of a very high quality is used, and, hence, the obtained insulated gate transistor exhibits excellent electric characteristics. At the same time, the pixel electrode 3 can be formed to a size of the order of microns by miniaturization technology, making it possible to fabricate a semiconductor device for an active matrix liquid crystal panel having a high density and a fine structure.

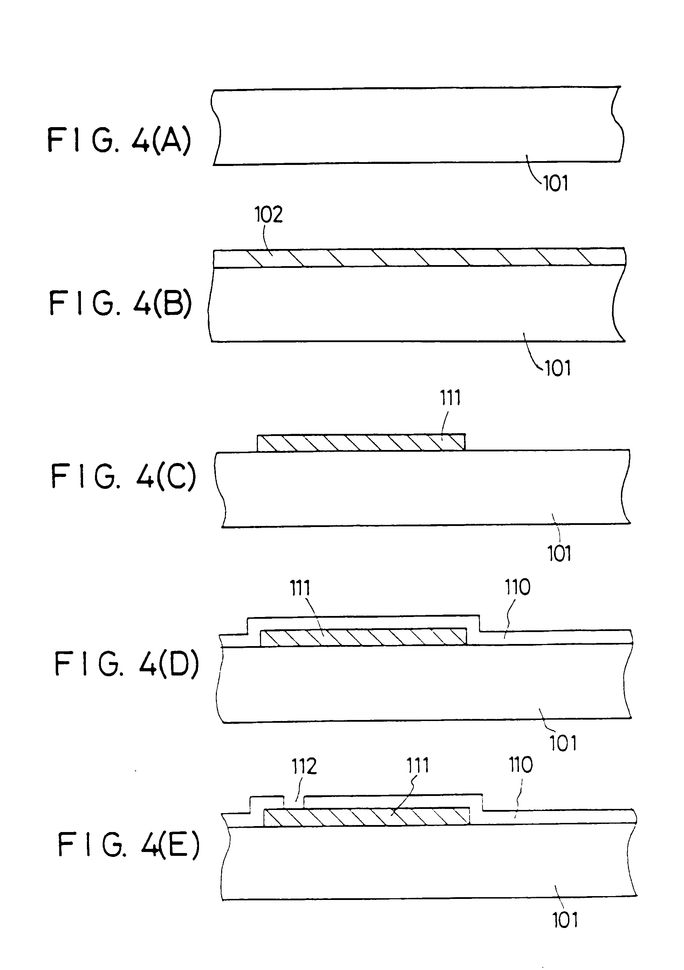

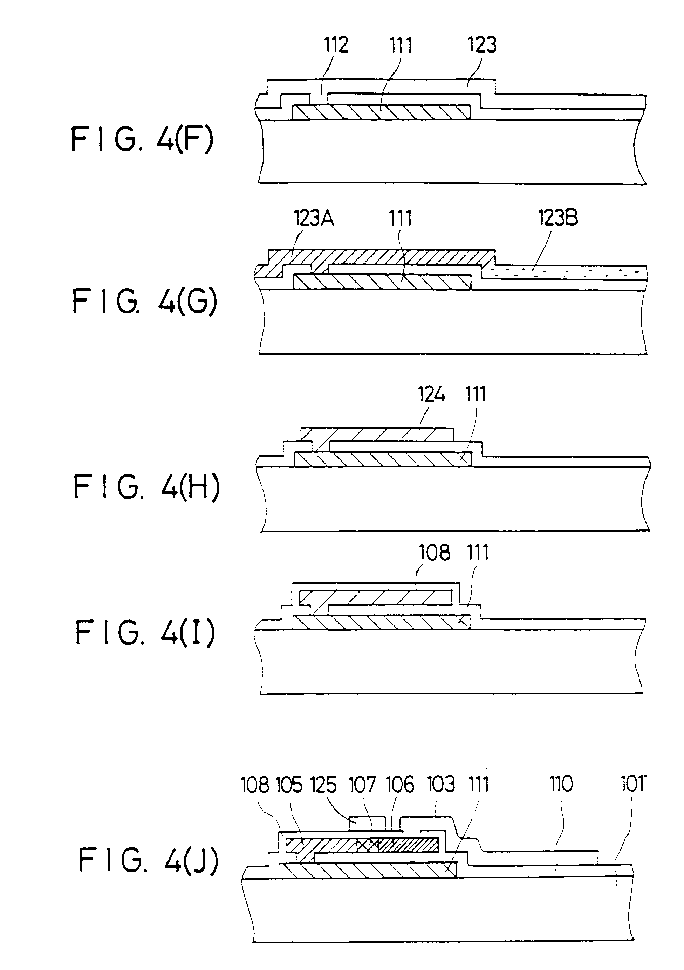

Figure 3 shows an embodiment in which the single crystal semiconductor film 23 is formed by thermo-compression bonding. Referring to Figure 4, another embodiment, where the single crystal semiconductor film is formed by an epitaxial method instead of thermo-compression bonding, is illustrated. First, a transparent aluminium oxide substrate 101, such as sapphire, is used as the support substrate as shown in Figure 4(A). Next, as shown in Figure 4(B), a single crystal silicon film 102 is hetero-epitaxially grown using the crystal of the aluminium oxide 101 as a seed.

In the polycrystalline form, aluminium oxide has a coefficient of thermal expansion that is closer to that of silicon than that of quartz. If polycrystalline aluminium oxide is used as the support substrate of the embodiment shown in Figure 3, the thermal stress is small and the crystallinity of the single crystal silicon film formed thereon can be maintained even after the semiconductor processing at a high temperature. In Figure 4 showing a process where single crystal aluminium oxide is used, it is possible to grow the single crystal silicon film 102 hetero-epitaxially thereon as shown in Figure 4(B).

Next, the single crystal silicon film 102 that is grown is patterned as shown in Figure 4(C) to form a light-shielding film 111. Then, an insulating film 110 is formed as shown in Figure 4(D), and a hole 112 is made in a portion thereof, so that the surface of the single crystal silicon film 111 is partially exposed as shown in Figure 4(E). Next, an amorphous or polycrystalline semiconductor film 123 is formed as shown in Figure 4(F).

The single crystal silicon crystal film 111 and the semiconductor film 123 are in contact with each other by way of the hole 112. If the heat treatment is carried out in this state at a high temperature, the semiconductor 123 grows laterally and epitaxially with the single crystal silicon film 111 in the hole as a seed. As shown in Figure 4(G), therefore, the region 123A close to the hole is transformed into a single crystal. The region 123B that is not transformed into a single crystal is kept in a polycrystalline form.

Although Figure 4(F) illustrates an example in which the polycrystalline semiconductor film 123 is, first, formed and is then grown laterally and epitaxially by a heat treatment, it should be noted that the single crystal semiconductor film, as shown in Figure 4(G), can also be formed by gas-source epitaxy or liquid-phase epitaxy from the state shown in Figure 4(E). Use can be made of a silicon film or a GaAs film as a semiconductor film.

Next, as shown in Figure 4(H), a region 124 that serves as the substrate of a transistor is patterned. Next, as shown in Figure 4(1), a gate insulating film 108 is formed and, finally, a transistor is formed in which a transparent electrode 103 is connected with a drain region 106 as shown in Figure 4(J). The conductance of a channel region 107 between a source region 105 and the drain region 106 is controlled through a gate electrode 125 and the light-shielding film 111. Figure 4(J) illustrates an example in which the light-shielding film 11 is connected to the source region 105. In Figure 4(G), the single crystal region is grown laterally and epitaxially by a length of 3µm to 5µm, enabling a single crystal transistor to be formed on the insulating film as shown in Figure 4(J).

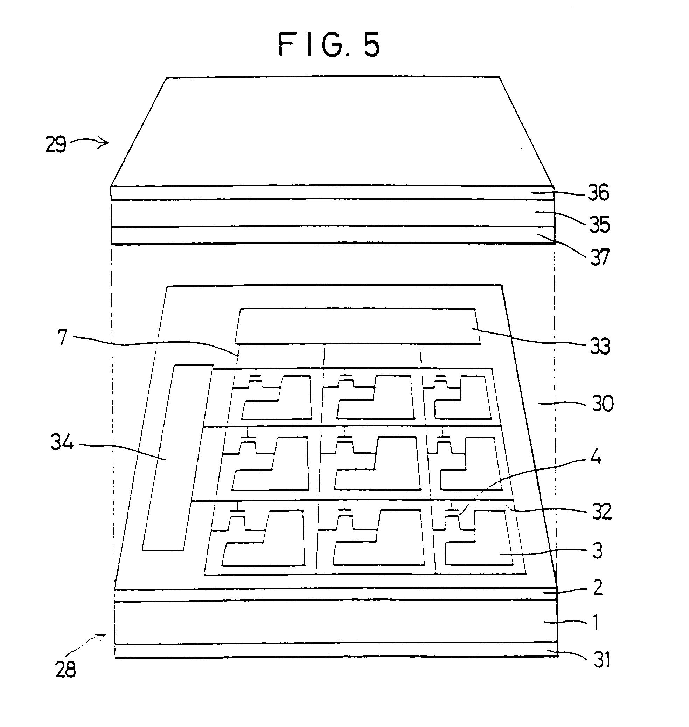

Figure 5 shows an optical valve device that is assembled using the semiconductor device of the present invention. As shown, the light valve device comprises a semiconductor device 28, a substrate 29 facing the semiconductor device 28, and a layer of an electro-optical material, for example, a liquid crystal layer 30, between the semiconductor device 28 and the facing substrate 29. In the semiconductor device 28, there are pixel electrodes or drive electrodes 3 that define pixels, and switching elements 4 for activating the drive electrodes 3 in response to predetermined signals.

The semiconductor device 28 consists of the support substrate 1 composed of quartz glass and the laminated layer structure 2 formed on the support substrate 1. In addition, a polarizer plate 31 is adhered to the back surface of the support substrate 1. The switching elements 4 are formed in the single crystal silicon semiconductor thin film included in the stacked-layer structure 2. The switching elements 4 are constituted by a plurality of insulated gate field-effect transistors arranged in a matrix. The source region of each transistor is connected to a corresponding pixel electrode 3, the main gate electrode is connected to a scanning line 32, and the drain electrode is connected to a signal line 7.

The semiconductor device 28 further includes an X-driver 33 connected to the signal lines 7 arranged in columns, and a Y-driver 34 connected to the scanning lines 32 arranged in rows. The facing substrate 29 comprises a glass substrate 35, a polarizing plate 36 adhered to the outer surface of the glass substrate 35, and a facing electrode or common electrode 37 formed on the inner surface of the glass substrate 35.

The light-shielding layer is connected to the source region or the drain region of the corresponding transistor. Thereby, a predetermined voltage is applied to the light-shielding layer to effectively prevent leakage current from flowing due to the back gating. By controlling the voltage applied to the light-shielding layer, furthermore, the threshold voltage of the channel region can be set to a desired value.

Operation of a light valve device not part of the invention will now be described in detail with reference to Figure 5. The main gate and sub-gate electrodes of each switching element 4 are connected in common to the scanning line 32, and are supplied with scanning signals from the Y-driver 34. Therefore, the turn-on/off of the switching elements 4 is controlled line by line. A data signal output from the X-driver 33 is applied, via the signal line 7, to a selected switching element 4 that has been turned on. The applied data signal is transmitted to the corresponding pixel electrode 3 to excite it and acts upon the liquid crystal layer 30, so that its transmission factor becomes substantially 100%. When not selected, on the other hand, the switching element 4 is left non-conductive and maintains the data signal written on the pixel electrode as electric charge. Here, the liquid crystal layer 30 has a large resistivity and usually operates a capacitive element.

An on/off current ratio is used to represent the switching performance of the switching elements 4. The current ratio necessary for operating the liquid crystal can easily be found from the write time and the holding time. For instance, when the data signal is a televison signal, more than 90% of the data signal must be written within about 60 µsec of one scanning period. On the other hand, more than 90% of the electric charge must be retained for a period of one field, which is about 16 msec. Therefore, the current ratio must be at least of the order of ten thousand. In this respect, according to the present invention, the conductance of the channel region is controlled from both surfaces thereof by the main gate and sub-gate electrodes, and the leakage current is substantially wholly eliminated during the off period. The on/off ratio of the switching elements having such a structure is of the order of a hundred thousand or greater. It is, therefore, possible to obtain a light valve device of an active matrix type having a very fast signal response characteristic.

According to the present invention as described above, a pair of main gate and sub-gate electrodes arranged on both sides of the transistor channel region are formed using a light-shielding material, such as polysilicon, whereby light is effectively blocked from entering the channel region from outside, making it possible effectively to prevent the occurrence of leakage current by the photo-electric effect. Moreover, since the transistor channel region formed in the semiconductor thin film is controlled from the upper and lower sides thereof by the main gate electrode and by the light-shielding layer composed of an electrically conductive material, i.e. by the sub-gate electrode, so-called back gating is effectively prevented, and a thin-film transistor having an excellent on/off ratio is obtained. As a result, a semiconductor device for driving light valves of a flat plate type can be obtained, which features very high response characteristics and is free from erroneous operation. In addition, by forming the switching elements consisting of insulated gate field-effect transistors in the semiconductor thin film of single crystal silicon, it is possible to obtain a flat-type semiconductor device for driving light valves that has a very fine and very large scale integration structure.

## Claims

1. A semiconductor device for an active matrix device, said semiconductor device comprising:
a composite substrate (1,2) having a stacked layer structure comprising in a layered order a support substrate (1) composed of a light transmitting electrically insulating material, a light shielding thin film (11), an insulating film (10) and a semiconductor thin film (5, 6, 7);
a transparent pixel electrode (3) formed on a portion of said composite substrate where at least said light shielding thin film is removed; and
a switching element (4) connected electrically to said transparent electrode and comprising a transistor having a source (6), drain (5) and a channel region (7) in said semiconductor thin film and a main gate electrode (9) for controlling the conduction in said channel region, wherein the light shielding thin film layer is disposed on the side opposite to said main gate electrode with respect to said channel region, characterised in that
the semiconductor thin film (5, 6, 7) is composed of a single crystal silicon, and in that
the light shielding thin film (11) is electrically connected to either of the source or drain so as to form a sub-gate for the switching element.

2. A semiconductor device according to claim 1, characterised in that the light shielding thin film is made of polysilicon.

3. A semiconductor device according to claim 1, characterised in that the light shielding thin film comprises a single layer film or a multi-layer film and includes at least one of germanium, silicon-germanium and silicon.

4. A semiconductor device according to any preceding claim, characterised in that the insulating film includes at least one of silicon nitride and silicon oxide.

5. A semiconductor device according to any preceding claim, characterised in that the light shielding thin film is disposed on a ground film (24) on the support substrate and in that the ground film is made of oxynitride or silicon oxide.

6. A method of fabricating a semiconductor device as claimed in any one of the previous claims, comprising:
preparing the composite substrate (1;101);
forming the switching element in said semiconductor thin film;
forming the semiconductor thin film of a single crystal; and
a further step of forming a through hole (112) in said insulating layer so as to electrically couple said light shielding thin film to either said source or drain of said switching element.

7. A method as claimed in claim 6, wherein said preparation of said composite substrate comprises polishing said semiconductor thin film followed by bonding to said insulating layer by thermo-compression bonding.

8. A method as claimed in claim 6, wherein said preparation of said composite substrate comprises:
forming said insulating layer of SiO₂ on the semiconductor thin film layer (2) by thermal oxidation or chemical vapour deposition;
forming said light shielding thin film of polysilicon by chemical vapour deposition;
polishing the surface of the light shielding thin film; and
forming on said light shielding thin film the following in the order stated:
an SiO₂ layer by thermal oxidation or chemical vapour deposition;
a silicon nitride film by chemical vapour deposition;
a further SiO₂ layer by thermal or chemical vapour deposition; and
bonding said supporting substrate to said further SiO₂ layer by thermo-compression bonding.

9. A method as claimed in claim 7 or 8, further comprising thinning said semiconductor thin film after bonding.

10. A method as claimed in claim 9, wherein the step of thinning the single crystal silicon substrate (23) involves a polishing process.

11. A method as claimed in claim 9, wherein the step of thinning the single crystal silicon substrate (23) involves an etching process.

12. A light valve device comprising a plurality of semiconductor devices as claimed in any one of claims 1 to 5 arranged in a matrix, said device further comprising:
an opposed substrate (29) opposite to said support substrate with said light shielding thin film and semiconductor thin film disposed therebetween; and
an electro-optical material (30) disposed in the gap between said composite substrate and said opposed substrate for optically changing in accordance with energisation of said switching element.

## Patentansprüche

1. Halbleitervorrichtung für eine Aktivmatrixvorrichtung, wobei die Halbleitervorrichtung umfaßt:
ein Verbundsubstrat (1, 2) mit einer gestapelten Schichtstruktur, umfassend in Schichtungsreihenfolge ein aus einem lichtdurchlässigen elektrisch isolierenden Material gebildetes Tragsubstrat (1), einen dünnen Lichtabschirmfilm (11), einen Isolationsfilm (10) und einen dünnen Halbleiterfilm (5, 6, 7);
eine transparente Pixelelektrode (3), die an einem Bereich des Verbundsubstrats gebildet ist, in dem wenigstens der dünne Lichtabschirmfilm entfernt ist; und
ein Schaltelement (4), das elektrisch mit der transparenten Elektrode verbunden ist und einen Transistor mit einem Source-Bereich (6), einem Drain-Bereich (5) und einem Kanalbereich (7) im dünnen Halbleiterfilm sowie eine Haupt-Gate-Elektrode (9) zum Steuern der Leitung im Kanalbereich aufweist, wobei die dünne Lichtabschirmfilmschicht bezüglich des Kanalbereichs an der der Haupt-Gate-Elektrode entgegengesetzten Seite angeordnet ist,
dadurch gekennzeichnet, daß
der dünne Halbleiterfilm (5, 6, 7) aus einkristallinem Silicium gebildet ist, und
daß der dünne Lichtabschirmfilm (11) elektrisch mit Source oder mit Drain verbunden ist, um ein Sub-Gate für das Schaltelement zu bilden.

2. Halbleitervorrichtung nach Anspruch 1,
dadurch gekennzeichnet, daß
der dünne Lichtabschirmfilm aus Polysilicium gebildet ist.

3. Halbleitervorrichtung nach Anspruch 1,
dadurch gekennzeichnet, daß
der dünne Lichtabschirmfilm einen Einschichtfilm oder einen Mehrschichtfilm umfaßt und Germanium und/oder Silicium-Germanium und/oder Silicium enthält.

4. Halbleitervorrichtung nach einem der vorhergehenden Ansprüche,
dadurch gekennzeichnet, daß
der Isolationsfilm Siliciumnitrid und/oder Siliciumoxid enthält.

5. Halbleitervorrichtung nach einem der vorhergehenden Ansprüche,
dadurch gekennzeichnet, daß
der dünne Lichtabschirmfilm auf einem Grundfilm (24) auf dem Tragsubstrat angeordnet ist, und daß der Grundfilm aus Oxynitrid oder Siliciumoxid gebildet ist.

6. Verfahren zur Herstellung einer Halbleitervorrichtung nach einem der vorhergehenden Ansprüche, umfassend:
Bereitstellen des Verbundsubstrats (1; 101);
Bilden des Schaltelements im dünnen Halbleiterfilm;
Bilden des dünnen Halbleiterfilms aus einem Einkristall; und
einen weiteren Schritt des Bildens eines Durchgangslochs (112) in der Isolationsschicht, um den dünnen Lichtabschirmfilm entweder an Source oder Drain des Schaltelements elektrisch zu koppeln.

7. Verfahren nach Anspruch 6, wobei die Bereitstellung des Verbundsubstrats ein Polieren des dünnen Halbleiterfilms und ein anschließendes Verbinden mit der Isolationsschicht durch Thermokompressions-Verbinden umfaßt.

8. Verfahren nach Anspruch 6, wobei die Bereitstellung des Verbundsubstrats umfaßt:
Bilden der Isolationsschicht aus SiO₂ auf der dünnen Halbleiterfilmschicht (2) durch thermische Oxidation oder chemische Gasphasenabscheidung;
Bilden des dünnen Lichtabschirmfilms aus Polysilicium durch chemische Gasphasenabscheidung;
Polieren der Oberfläche des dünnen Lichtabschirmfilms; und
Bilden, in der genannten Reihenfolge, der folgenden auf dem dünnen Lichtabschirmfilm:
eine SiO₂-Schicht durch thermische Oxidation oder chemische Gasphasenabscheidung;
einen Siliciumnitridfilm durch chemische Gasphasenabscheidung;
eine weitere SiO₂-Schicht durch thermische oder chemische Gasphasenabscheidung; und
Verbinden des Tragsubstrats mit der weiteren SiO₂-Schicht durch Thermokompressions-Verbinden.

9. Verfahren nach Anspruch 7 oder 8, ferner umfassend ein Dünnmachen des dünnen Halbleiterfilms nach dem Verbinden.

10. Verfahren nach Anspruch 9, worin der Schritt des Dünnmachens des einkristallinen Silicium-Substrats (23) einen Polierprozeß beinhaltet.

11. Verfahren nach Anspruch 9, worin der Schritt des Dünnmachens des einkristallinen Silicium-Substrats (23) einen Ätzprozeß beinhaltet.

12. Lichtventilvorrichtung, umfassend eine Mehrzahl von Halbleitervorrichtungen nach einem der Ansprüche 1 bis 5, die in einer Matrix angeordnet sind, wobei die Vorrichtung ferner umfaßt:
ein Gegensubstrat (29), das dem Tragsubstrat gegenüberliegt, wobei der dünne Lichtabschirmfilm und der dünne Halbleiterfilm dazwischen angeordnet sind; und
ein in der Lücke zwischen dem Verbundsubstrat und dem Gegensubstrat angeordnetes elektrooptisches Material (30) zur optischen Veränderung nach Maßgabe der Erregung des Schaltelements.

## Revendications

1. Dispositif à semiconducteur pour un dispositif de matrice active, ledit dispositif à semiconducteur comprenant :
un substrat composite (1, 2) ayant une structure à couches empilées, comprenant, dans l'ordre des couches, un substrat de support (1) se composant d'un matériau électriquement isolant transmettant la lumière, un film mince protégeant de la lumière (11), un film isolant (10) et un film mince semiconducteur (5, 6, 7) ;
une électrode de pixel transparente (3) formée sur une partie dudit substrat composite où au moins ledit film mince protégeant de la lumière est retiré ; et
un élément de commutation (4) électriquement connecté à ladite électrode transparente et comprenant un transistor ayant une source (6), un drain (5) et une région de canal (7) dans ledit film mince semiconducteur et une électrode de grille principale (9) permettant de commander la conduction dans ladite région de canal, dans lequel la couche formée par le film mince protégeant de la lumière est disposée sur la face opposée à ladite électrode de grille principale par rapport à ladite région de canal, caractérisé en ce que
le film mince semiconducteur (5, 6, 7) se compose d'un silicium monocristallin et en ce que
le film mince protégeant de la lumière (11) est électriquement connecté soit à la source, soit au drain afin de former une sous-grille pour l'élément de commutation.

2. Dispositif à semiconducteur selon la revendication 1, caractérisé en ce que le film mince protégeant de la lumière est faite en polysilicium.

3. Dispositif à semiconducteur selon la revendication 1, caractérisé en ce que le film mince protégeant de la lumière comprend un film monocouche ou multicouche et comprend au moins un élément parmi le germanium, le silicium-germanium et le silicium.

4. Dispositif à semiconducteur selon l'une quelconque des revendications précédentes, caractérisé en ce que le film isolant comprend au moins un élément parmi le nitrure de silicium et l'oxyde de silicium.

5. Dispositif à semiconducteur selon l'une quelconque des revendications précédentes, caractérisé en ce que le film mince protégeant de la lumière est disposé sur un film de base (24) sur le substrat de support et en ce que le film de base est fait en oxynitrure ou en oxyde de silicium.

6. Procédé de fabrication d'un dispositif à semiconducteur selon l'une quelconque des revendications précédentes, comprenant les étapes consistant à:
préparer le substrat composite (1 ; 101) ;
former l'élément de commutation dans ledit film mince semiconducteur ;
former le film mince semiconducteur à partir d'un monocristal ; et comprenant
une autre étape consistant à former un trou traversant (112) dans ladite couche isolante afin de coupler électriquement ledit film mince protégeant de la lumière, soit à ladite couche, soit audit drain dudit élément de commutation.

7. Procédé selon la revendication 6, dans lequel ladite préparation dudit substrat composite comprend l'étape consistant à polir ledit film mince semiconducteur puis à le lier à ladite couche isolante par liaison par thermocompression.

8. Procédé selon la revendication 6, dans lequel ladite préparation dudit substrat composite comprend les étapes consistant à :
former ladite couche isolante de SiO2 sur la couche de film mince semiconducteur (2) par oxydation thermique ou dépôt chimique en phase vapeur ;
former ledit film mince protégeant de la lumière en polysilicium par dépôt chimique en phase vapeur ;
polir la surface du film mince protégeant de la lumière ; et
former sur ledit film mince protégeant de la lumière les éléments suivants dans l'ordre indiqué :
une couche de SiO2 par oxydation thermique ou dépôt chimique en phase vapeur ;
un film de nitrure de silicium par dépôt chimique en phase vapeur;
une autre couche de SiO2 par oxydation thermique ou dépôt chimique en phase vapeur ; et
lier ledit substrat de support à ladite autre couche de SiO2 par liaison par thermocompression.

9. Procédé selon la revendication 7 ou 8, comprenant en outre l'étape consistant à amincir ledit film semiconducteur après la liaison.

10. Procédé selon la revendication 9, dans lequel l'étape consistant à amincir le substrat en silicium monocristallin (23) met en oeuvre une opération de polissage.

11. Procédé selon la revendication 9, dans lequel l'étape consistant à amincir le substrat en silicium monocristallin (23) met en oeuvre une opération d'attaque chimique.

12. Dispositif formant modulateur de lumière comprenant une pluralité de dispositifs à semiconducteur selon l'une quelconque des revendications 1 à 5 agencés en matrice, ledit dispositif comprenant en outre :
un substrat opposé (29) situé en face dudit substrat de support avec ledit film mince protégeant de la lumière et ledit film mince semiconducteur disposés entre eux ; et
un matériau électro-optique (30) disposé dans l'intervalle séparant ledit substrat composite et ledit substrat opposé pour effectuer une modification optique selon l'excitation dudit élément de commutation.
